(19) Europäisches Patentamt
European Patent Office
Office européen des brevets

(11) **EP 4 739 070 A1**

(12) **EUROPEAN PATENT APPLICATION**

(43) Date of publication:
06.05.2026 Bulletin 2026/19

(21) Application number: 25207398.6

(22) Date of filing: 08.10.2025

(51) International Patent Classification (IPC):
*H10W 70/685* (2026.01)     *H10W 70/69* (2026.01)
*H10W 70/692* (2026.01)

(52) Cooperative Patent Classification (CPC):
**H10W 70/685; H10W 70/69;** H10W 70/692

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **31.10.2024 US 202463714154 P**

(71) Applicant: **Absolics Inc.**
**Covington, GA 30014 (US)**

(72) Inventors:
• **KIM, Sungjin**
**Georgia, 30014 (US)**
• **KIM, Jincheol**
**18469 Hwaseong-si (KR)**

(74) Representative: **BCKIP Part mbB**
**MK1**
**Landsbergerstraße 98, 3.Stock**
**80339 München (DE)**

(54) **PACKAGING SUBSTRATE**

(57)     An embodiment relates to a packaging substrate comprises: a glass core; a wiring layer; and an insulating layer, wherein the glass core is a plate-shaped glass in which vias are disposed, the wiring layer is an electrically conductive layer disposed on a surface of the glass core, the insulating layer is a layer disposed in a space between the electrically conductive layers and comprising a mixture of a polymer resin and an insulating filler, the packaging substrate has an upper surface on which a semiconductor element is mounted and a lower surface facing the upper surface, the insulating layer disposed on an upper portion of the glass core is an upper insulating layer, a cover layer is further disposed on the upper insulating layer, the insulating layer disposed on a lower portion of the glass core is a lower insulating layer, and a solder resist layer is further disposed on the lower insulating layer.

A–A'

FIG. 2

EP 4 739 070 A1

## Description

This application claims the priority of U.S. Provisional Patent Application No. 63/714,154, filed October 31, 2024.

## BACKGROUND

Technical Field

An embodiment relates to a packaging substrate in which the difference in physical properties between the upper and lower portions of a glass core is adjusted, improving thermal shock resistance, impact resistance, durability, reliability, etc.

In the manufacture of electronic components, implementing a circuit on a semiconductor wafer is referred to as a front-end (FE) process, and assembling the wafer into a state in which it can be used in an actual product is referred to as a back-end (BE) process, in which a packaging process is included.

Four core technologies of the semiconductor industry that have enabled the rapid advancement of electronic products in recent years comprise semiconductor technology, semiconductor packaging technology, manufacturing process technology, and software technology. Semiconductor technology has evolved in various forms, such as a line width at the sub-micrometer or nanometer level, more than ten million cells, high-speed operation, and high heat dissipation. However, the technology for perfectly packaging such semiconductors has not kept pace. Accordingly, the electrical performance of a semiconductor may be determined by the packaging technology and the electrical connection therefrom rather than by the performance of the semiconductor technology itself.

As materials for packaging substrates, ceramics or resins are applied. In the case of ceramic substrates, their high resistance or high dielectric constant makes it difficult to mount high-performance, high-frequency semiconductor elements thereon. In the case of resin substrates, it is relatively possible to mount high-performance, high-frequency semiconductor elements; however, there is a limitation in reducing the wiring pitch.

Recently, research has been underway to apply glass substrates for high-end packaging substrates. By forming through holes in a glass substrate and applying a conductive material to the through holes, the wiring length between the element and the motherboard may be shortened, and excellent electrical characteristics may be achieved.

Related arts include Korean Patent Publication No. 10-2020-0030430 and Korean Patent Publication No. 10-2023-0145447.

## SUMMARY

**In** some embodiments, a packaging substrate in which a difference in physical properties between an upper portion and a lower portion of a glass core is adjusted, thereby improving thermal shock resistance, impact resistance, durability, reliability, etc., is disposed.

According to an embodiment, a packaging substrate according to one embodiment includes: a glass core; a wiring layer; and an insulating layer, wherein the glass core is a plate-shaped glass in which vias are disposed, the wiring layer is an electrically conductive layer disposed on a surface of the glass core, and the insulating layer is a layer disposed in a space between the electrically conductive layers and containing a mixture of a polymer resin and insulating particles. The packaging substrate has an upper surface on which a semiconductor element is mounted and a lower surface facing the upper surface. The insulating layer disposed on an upper portion of the glass core is an upper insulating layer, a cover layer is further disposed on the upper insulating layer, the insulating layer disposed on a lower portion of the glass core is a lower insulating layer, and a solder resist layer is further disposed on the lower insulating layer.

A flexibility index (FI) is a value represented by Equation 1 below.

$$[\text{Equation 1}]$$

$$FI = 10{,}000 \times (E' \times \tan \delta) / (H \times Er)$$

In Equation 1, E' denotes a storage modulus (GPa), $\tan \delta$ denotes a loss tangent, H denotes a hardness (GPa), and Er denotes a reduced modulus (GPa).

The FI of the cover layer is greater than the FI of the solder resist layer.

The FI of the cover layer may be 7.5 or more and 8.3 or less.

The FI of the solder resist layer may be 3.9 or more and 4.6 or less.

The storage modulus (E') of the packaging substrate may be 0.73 GPa or more and 0.85 GPa or less.

The loss tangent (tan δ) of the packaging substrate may be 0.0080 or more and 0.0090 or less.

The hardness (H) of the cover layer may be 0.55 GPa or more and 0.65 GPa or less.

The hardness (H) of the solder resist layer may be 0.82 GPa or more and 0.93 GPa or less.

The reduced modulus (Er) of the cover layer may be 13.5 GPa or more and 15.0 GPa or less.

The reduced modulus (Er) of the solder resist layer may be 17.8 GPa or more and 19.6 GPa or less.

A difference between the FI of the cover layer and the FI of the solder resist layer may be 3.6 or more and 4.2 or less.

## BRIEF DESCRIPTION OF THE DRAWINGS

FIG. 1 is a view of a packaging substrate on which a semiconductor element manufactured according to an embodiment is mounted.

FIG. 2 is a conceptual cross-sectional view taken along line A-A' of FIG. 1.

FIG. 3 is a conceptual cross-sectional view illustrating a cross section in which an upper insulating layer and a lower insulating layer are exposed in the packaging substrate manufactured according to an embodiment.

FIG. 4 is a conceptual cross-sectional view illustrating a cross section in which a cover layer and a solder resist layer are further disposed on FIG. 3.

## DESCRIPTION OF THE EMBODIMENTS

Hereinafter, exemplary embodiments of the present invention will be described in detail with reference to the accompanying drawings so that those skilled in the art to which the present invention pertains may readily carry out the invention. However, the present invention may be embodied in various different forms and is not limited to the embodiments described herein. Throughout the specification, the same reference numerals are assigned to like elements.

In the present specification, the term "a combination thereof" included in a Markush-type expression means a mixture or combination of one or more components selected from the group of components described in the Markush-type expression, and means comprising one or more selected from the group of the components.

In the present specification, terms such as "first" and "second," or "A" and "B," are used to distinguish identical terms from each other. In addition, unless the context clearly indicates otherwise, singular expressions include plural expressions.

In the present specification, the expression "~ group" may mean comprising a compound corresponding to "~" or a derivative of "~" within a compound.

In the present specification, the expression "B is located on A" means that B is located directly in contact with A or that B is located on A with another layer interposed therebetween, and is not to be construed as limited to B being located in contact with a surface of A.

In the present specification, the expression "B is connected to A" means that A and B are directly connected or connected through another component interposed therebetween, and unless otherwise specified, is not to be construed as limited to A and B being directly connected.

In the present specification, unless otherwise specified, a singular expression is to be construed as including both singular and plural meanings as interpreted in context.

In the present specification, the shapes, relative sizes, and angles of the elements in the drawings may be exaggerated for the purpose of illustration and explanation, and the scope of rights shall not be construed as being limited to the drawings.

In the present specification, the expression "A and B are adjacent" means that A and B are in contact with each other or positioned close to each other without being in contact, and unless otherwise specified, is not to be construed as limited to A and B being in contact.

In the present specification, unless otherwise specified, the physical property values of each component in the packaging substrate are to be interpreted as those measured at room temperature, which is 20°C to 25°C.

Hereinafter, in the embodiment, the packaging substrate may be a singulated packaging substrate. The packaging substrate may also be a strip substrate in which a plurality of individual packaging substrates are arranged with a dummy region therebetween; a quad substrate in which a dummy region is disposed between a plurality of the strip substrates; or a panel substrate in which a dummy region is disposed between a plurality of the quad substrates. For convenience of description, all of these are referred to as packaging substrates.

Hereinafter, unless otherwise specified regarding temperature, the DMA measurement value described refers to the average value in the range of 25°C to 85°C among DMA data.

The packaging substrate may, depending on the design, have, selectively on its upper and/or lower side, wiring layers, insulating layers, a cover layer, a solder resist layer, and the like arranged in multiple layers in various configurations. In addition, the heights (thicknesses) of the wiring layers or insulating layers disposed in the packaging substrate may vary. Despite such design variations, the glass core, as a support of the packaging substrate, should stably support the upper and lower wiring layers and insulating layers; and the layers disposed on the upper and lower sides of the glass core should have sufficient flexibility to reduce stress applied to the glass core, while having a hardness at or above an appropriate level so as to protect wiring layers and the like disposed within the layers.

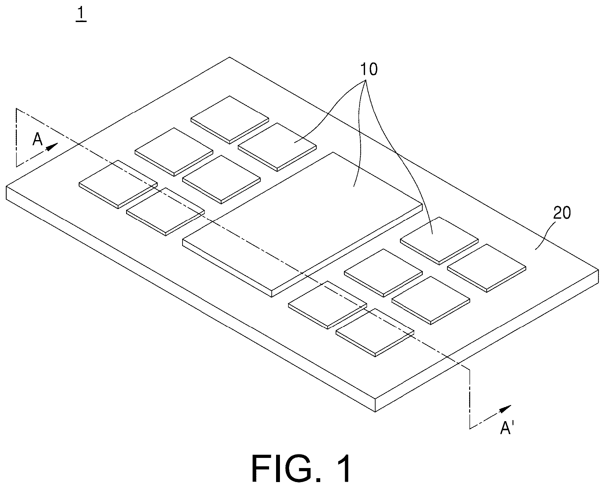

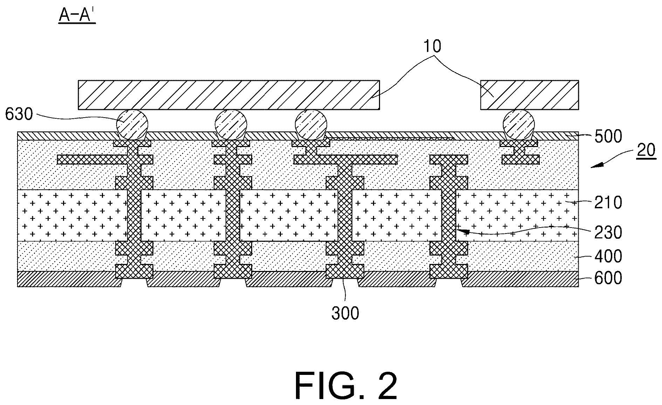

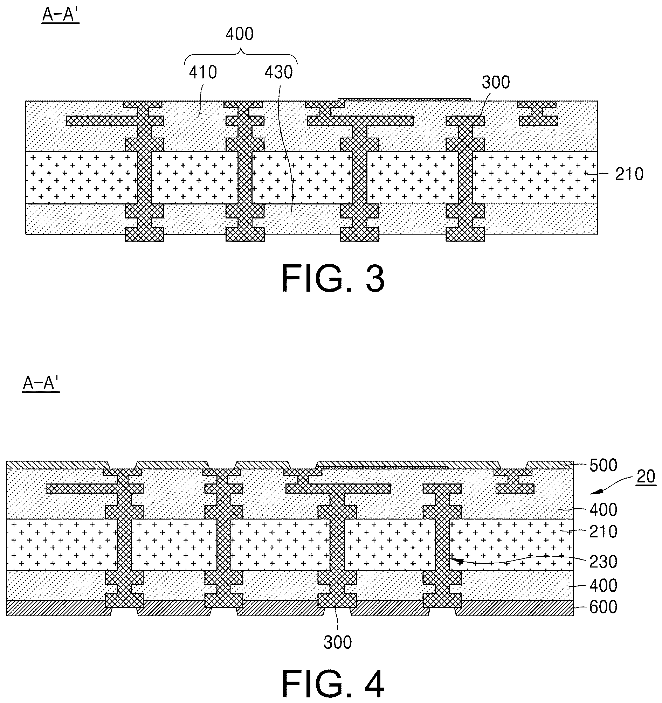

FIG. 1 is a packaging substrate on which a semiconductor element manufactured according to an embodiment is mounted, and FIG. 2 is a conceptual cross-sectional view taken along line A-A' of FIG. 1. FIG. 3 is a conceptual cross-sectional view illustrating a cross section in which an upper insulating layer and a lower insulating layer are exposed in the packaging substrate manufactured according to an embodiment. Hereinafter, the disclosure will be described in detail with reference to FIGS. 1 to 3.

In order to achieve the above object, a packaging substrate 20 according to one embodiment of the present disclosure comprises: a glass core 210; a wiring layer 300; and an insulating layer 400.

The glass core 210 is a plate-shaped glass in which vias 230 are disposed.

The wiring layer 300 is an electrically conductive layer disposed on a surface of the glass core 210. The wiring layer 300 may be arranged in a predetermined pattern. The wiring layer 300 comprises both a circuit layer connected in a planar direction and through electrodes connected in a vertical direction.

The insulating layer 400 is a layer having electrical insulating properties and disposed in a space between the electrically conductive layers. The insulating layer 400 may be a layer comprising a mixture of a polymer resin and insulating particles, and, for example, an Ajinomoto Build-up Film (ABF) of Ajinomoto Co., Inc. may be applied thereto, but is not limited thereto.

The packaging substrate 20 has an upper surface on which a semiconductor element 10 is mounted and/or a lower surface facing the upper surface (see FIGS. 1 and 2).

The insulating layer 400 disposed on an upper portion of the glass core 210 is referred to as an upper insulating layer 410. The upper insulating layer 410 may have a part or the whole of the wiring layer 300 embedded therein. The insulating layer 400 disposed on a lower portion of the glass core 210 is referred to as a lower insulating layer 430. The lower insulating layer 430 may have a part or the whole of the wiring layer 300 embedded therein (see FIG. 3).

The packaging substrate 20 may further comprise a cover layer 500 disposed on an upper portion of the upper insulating layer 410. The packaging substrate 20 may further comprise a solder resist layer 600 disposed on a lower portion of the lower insulating layer 430 (see FIG. 4).

The cover layer 500 may comprise, for example, a polymer insulating layer such as a polyimide layer, or an inorganic insulating layer such as silica, but is not limited thereto.

The solder resist layer may comprise, for example, a solder resist or a composition for a solder mask.

The packaging substrate 20 may have a semiconductor element 10 disposed on the cover layer to constitute a packaging substrate 20 on which the semiconductor element is mounted. A bump 630 may be disposed between the packaging substrate 20 and the semiconductor element 10 (see FIGS. 1 and 2).

The upper insulating layer 410 and the lower insulating layer 430 may have the wiring layer arranged in a predetermined pattern. In addition, an insulating material may be disposed with a predetermined thickness and arrangement.

In a process of forming a redistribution layer, heating and cooling are repeated. For example, formation of the insulating layer requires a process of laminating and curing an organic-inorganic composite material in the form of a film, and in many cases, the curing is performed by thermal curing. This may apply thermal stress to the packaging substrate, particularly the glass core. In addition, during the manufacturing process, the substrate is transferred through various processes via cassettes, and inevitably, collision or vibration may be applied, which may impart mechanical shock to the packaging substrate, particularly the glass core. In such a thermal and mechanical stress environment, it is necessary to secure sufficient thermal shock resistance and impact resistance for the glass core, and for this purpose, the layers disposed above and below the glass core, such as the upper insulating layer and the lower insulating layer, need to have flexibility sufficient to reduce stress applied to the glass core, as well as surface hardness at an appropriate level to protect the wiring layer and the like disposed inside the layers.

In the embodiment, after reviewing various physical properties together, it was confirmed that when the flexibility index (FI) condition is satisfied, a packaging substrate satisfying all these characteristics can be manufactured, and the details thereof are described below.

A flexibility index FI is a value represented by Equation 1 below.

[Equation 1]

$$FI = 10,000 \times (E' \times \tan \delta) / (H \times Er)$$

In Equation 1, E' denotes a storage modulus (GPa), tan δ denotes a loss tangent, H denotes a hardness (GPa), and Er denotes a reduced modulus (GPa).

The storage modulus E' (GPa) and the loss tangent tan δ are values obtained by a DMA (Dynamic Mechanical Analyzer). The DMA measurement values are based on values measured by applying a frequency of 1 Hz. The equipment used is a DMA7100 manufactured by Hitachi, and the measured values may be output using a program provided by the manufacturer. The DMA measurement values may be obtained by placing each sample in the equipment and heating it for about 70 minutes over a range of about -40°C to about +210°C.

The hardness H (GPa) and the reduced modulus Er (GPa) are values obtained by a nanoindentation method.

Nanoindentation (nanoindentation, nano-pressing) is a method of measuring physical properties of a target by applying and removing a load to a target surface using an indenter having a predetermined geometric shape, continuously recording the load and indentation depth during the process, and analyzing an indentation load-displacement curve obtained therefrom. The method focuses on the plastic deformation that occurs during indentation and evaluates the physical properties of relatively thin thicknesses in a nondestructive manner.

The inventors determined that, because the nanoindentation method can measure the physical properties of a local region from the surface, the physical properties of each layer formed in the manufacturing process of the packaging substrate can be reliably measured from the surface of the layer.

The measurement of the physical properties of the packaging substrate is performed at a measurement point.

The measurement point is a single point on the surface of the packaging substrate.

The surface at the measurement point is selected from among the surface of the insulating layer, the surface of the cover layer, and the surface of the solder resist layer.

The measurement points are arranged in plurality on the surface, and, for example, measurement may be performed at ten measurement points.

The measurement points are disposed at intervals on the surface. For example, the measurement may be performed at ten measurement points arranged at intervals of 0.05 times or more of the surface length of the packaging substrate. The measurement may also be performed at ten measurement points arranged at intervals of 0.2 times or less of the surface length.

The surface length refers to the length of the longest axis on the surface of the packaging substrate. For example, in the case where the packaging substrate is in a quadrangular shape, the length of the diagonal is the surface length. For example, in the case where the packaging substrate is circular, the surface length is the diameter. In the case where the packaging substrate has a modified quadrangular or amorphous shape, the surface length is the longest measurable length on the surface. When the physical properties of the surface are measured at multiple measurement points in this way, not only the physical properties at each measurement point but also the differences in physical properties between the measurement points can be identified.

The measurement at the measurement points by the nanoindentation method may be in accordance with ISO 14577 standards.

The measurement at the measurement points by the nanoindentation method is based on a value obtained by applying a Berkovich-type diamond tip indenter at a maximum load of 25 mN. For example, a measurement device such as the NanoTest Vantage Platform (MICRO MATERIALS) may be applied, and the derivation of the measurement values may be performed using software provided by the manufacturer. In this case, the tip sharpness may be about 56.36 nm, and the effective radius may be about 68.67 ± 1.48 nm. The measurements may be based on values measured at a temperature of about 27°C and a relative humidity of about 25%.

The physical properties are measured at the measurement points regardless of the structure present below the surface. This relates to the fact that, regardless of the design shape of the pattern or whether a separate element is disposed in a cavity inside the glass core, the stress within the packaging substrate should be controlled to a certain level or less.

The specific measurement methods for DMA and nanoindentation are based on the measurement methods applied in experimental examples described later.

A difference between the FI of the cover layer 500 and the FI of the solder resist layer 600 may be 3.6 or more and 4.2 or less. The difference may be 3.6 or more, or 3.7 or more. The difference may also be 4.2 or less, or 4.1 or less. The units for the calculation of FI are (1/GPa), but FI is expressed without units in exponential form.

The flexibility index (FI) is an indicator related to the flexibility of the upper and lower portions of the glass core. If the difference in flexibility index between the upper and lower portions is too large, the balance of flexibility between the upper and lower portions may be lost, which may reduce the workability of the glass core or weaken the durability of the packaging substrate.

The FI of the cover layer 500 may be 7.5 or more and 8.3 or less. The FI of the cover layer represents the flexibility characteristics of the cover layer and the upper insulating layer.

The FI of the cover layer may be 7.5 or more, 7.7 or more, or 7.9 or more. The FI of the cover layer may also be 8.3 or less, or 8.2 or less. In such cases, the cover layer and the upper insulating layer may have sufficient flexibility. This may help prevent cracks or damage when the packaging substrate is subjected to thermal and mechanical stress.

The FI of the solder resist layer 600 may be 3.9 or more and 4.6 or less. The FI of the solder resist layer represents the flexibility characteristics of the solder resist layer and the lower insulating layer.

The FI of the solder resist layer may be 4.6 or less, 4.5 or less, 4.4 or less, or 4.3 or less. The FI of the solder resist layer may be 3.9 or more. In such cases, the solder resist layer and the lower insulating layer may have flexibility while maintaining sufficient mechanical strength. This may help prevent cracks or damage when the packaging substrate is subjected to thermal and mechanical stress.

The storage modulus (E') of the packaging substrate 20 may be 0.73 GPa or more and 0.85 GPa or less. The storage modulus (E') relates to the stiffness of the packaging substrate. The storage modulus (E') of the packaging substrate 20 may be 0.85 GPa or less, 0.83 GPa or less, or 0.81 GPa or less. The storage modulus (E') may also be 0.73 GPa or more, or 0.75 GPa or more. Within such a range, the packaging substrate may effectively cope with thermal shock and mechanical shock while maintaining appropriate stiffness.

The loss tangent (tan $\delta$) of the packaging substrate 20 may be 0.0080 or more and 0.0090 or less. The loss tangent (tan $\delta$) represents the energy absorbed and dissipated by the packaging substrate. When the loss tangent (tan $\delta$) of the packaging substrate 20 is within the above range, thermal deformation and mechanical shock may be effectively absorbed and distortion in signal transmission can be minimized.

The hardness (H) of the cover layer 500 may be 0.55 GPa or more and 0.65 GPa or less.

The hardness (H) of the cover layer 500 may be 0.56 GPa or more, 0.57 GPa or more, 0.58 GPa or more, or 0.59 GPa or more. The hardness (H) of the cover layer 500 may be 0.64 GPa or less, or 0.62 GPa or less. When the hardness is within such a range, the cover layer can maintain appropriate strength and flexibility.

The hardness (H) of the solder resist layer 600 may be 0.82 GPa or more and 0.93 GPa or less.

The hardness (H) of the solder resist layer 600 may be 0.83 GPa or more, 0.84 GPa or more, or 0.85 GPa or more. The hardness (H) of the solder resist layer 600 may be 0.93 GPa or less, 0.91 GPa or less, or 0.89 GPa or less.

The reduced modulus (Er) of the cover layer 500 may be 13.5 GPa or more and 15.0 GPa or less. The reduced modulus (Er) represents the ability of the cover layer to absorb and disperse external shock.

The reduced modulus (Er) of the cover layer 500 may be 13.7 GPa or more, 13.9 GPa or more, or 14.0 GPa or more. The reduced modulus (Er) of the cover layer 500 may be 14.8 GPa or less, or 14.6 GPa or less. In such cases, thermal shock and mechanical shock can be efficiently absorbed to maintain the stability of the substrate.

The reduced modulus (Er) of the solder resist layer 600 may be 17.8 GPa or more and 19.6 GPa or less. The reduced modulus (Er) of the solder resist layer 600 may be 18.0 GPa or more, 18.2 GPa or more, 18.4 GPa or more, or 18.6 GPa or more. The reduced modulus (Er) of the solder resist layer 600 may be 19.4 GPa or less, or 19.2 GPa or less. In such cases, sufficient shock absorption capability and mechanical stability can be provided.

A packaging substrate having such characteristics may have excellent physical properties.

For example, in a thermal shock test, the stress at failure of the packaging substrate may be 160 MPa or more. The stress at failure may be 162 MPa or more, or 168 MPa or more. The stress at failure may also be 190 MPa.

For example, in a thermal shock test, the strain of the packaging substrate may be 0.15% or less. The strain may be 0.14% or less, or 0.13% or less. The strain may be 0.05% or more. Such a characteristic indicates that deformation caused by thermal shock is negligible.

For example, in a three-point bending test, the bending strength of the packaging substrate may be 190 MPa or more. The bending strength may be 195 MPa or more, or 200 MPa or more. The bending strength may also be 230 MPa or less.

For example, in a three-point bending test, the bending modulus of the packaging substrate may be 5 GPa or more and 6 GPa or less.

Such a packaging substrate can have sufficient strength along with excellent flexibility.

Hereinafter, the present invention will be described in more detail through specific embodiments. The following embodiments are merely examples for aiding the understanding of the present invention, and the scope of the present invention is not limited thereto.

**Preparation Example**

1) Preparation of Example 1

A glass plate was cut into a size of 10 cm × 10 cm as a glass core, and then etched for 5 minutes in a mixed solution of 1.8 M hydrofluoric acid and 1.0 M nitric acid, rinsed with deionized water, and neutralized for 30 seconds with a 4.5 mol% sodium bicarbonate solution. After drying the glass core at 120°C for 30 minutes, titanium (Ti) 50 nm and copper (Cu) 120 nm seed layers were deposited on both the top and bottom surfaces by sputtering. The sputtering was performed at a power of 100 W in a 5 mTorr argon atmosphere.

On the seed layers, copper wiring layers having a thickness of 1.5 $\mu$m were formed on both the top and bottom surfaces by electroplating, using an electrolytic solution of 0.6 M copper sulfate and 0.2 M sulfuric acid, at 25°C and a current density of 10 mA/cm$^2$ for 15 minutes.

Subsequently, an Ajinomoto Build-up Film (ABF) having a thickness of 50 $\mu$m was laminated at 100°C, and then cured at 150°C for 1 hour. Titanium (Ti) 50 nm and copper (Cu) 1.5 $\mu$m wiring layers were additionally formed on both the top and bottom surfaces under the same conditions to complete electrical connection.

1-1) Preparation of Example 1-1: Cover Layer

On the top side of the packaging substrate (facing the semiconductor chip mounting side), a polyimide (PI) cover layer having a thickness of 10 $\mu$m was formed. A polyimide solution was spin-coated on the top surface of the packaging substrate. Spin coating was performed at 3000 rpm for 30 seconds, and after coating, a soft bake was performed at 80°C for 10 minutes. Thereafter, curing was performed at 350°C for 1 hour, with a heating rate of 4°C/min and a cooling rate of 2°C/min.

1-2) Preparation of Example 1-2: Solder Resist Layer

On the bottom side of the packaging substrate (facing the PCB bonding side), a solder resist layer having a thickness of 10 $\mu$m was formed. A composition for solder resist was applied by a screen printing method. After printing, preliminary drying was performed at 80°C for 15 minutes. Thereafter, curing was performed at 180°C for 1 hour, with a heating rate of 3°C/min. The fully laminated substrate was then heat-treated at 250°C for 1 hour under a vacuum of 10^-3 Torr to perform final bonding and property stabilization. In this process, the heating rate was adjusted to 2°C/min and the cooling rate to 1°C/min to minimize thermal stress. Finally, the completed substrate was stabilized for 24 hours in an environment of 23$\pm$2°C and 50$\pm$5% RH.

**2) Preparation of Example 2**

2-1) Preparation of Example 2-1: Cover Layer

The other conditions were applied in the same manner, except that the plating was performed at 25°C with a current density of 2.0 A/dm$^2$ for 15 minutes of electrolytic plating. The thickness of the copper wiring layer thus formed was 8.0 $\mu$m. The curing conditions for forming the insulating layer and the heat treatment conditions were also changed. The ABF lamination was performed at 100°C, 0.3 MPa for 55 seconds, and the heat treatment was performed at 215°C for 30 minutes under a vacuum of 10^-3 Torr.

On the top side of the packaging substrate (facing the semiconductor chip mounting side), a polyimide (PI) cover layer having a thickness of 9 $\mu$m was laminated. Spin coating was performed at 3200 rpm for 30 seconds, and curing was performed at 345°C for 55 minutes. The heating rate was 4.5°C/min, and the cooling rate was 2.5°C/min.

2-2) Preparation of Example 2-2: Solder Resist Layer

The other conditions were applied in the same manner, except that the plating was performed at 25°C with a current density of 2.0 A/dm$^2$ for 15 minutes of electrolytic plating. The thickness of the copper wiring layer thus formed was 8.0 $\mu$m. The curing conditions for forming the insulating layer and the heat treatment conditions were also changed. The ABF lamination was performed at 100°C, 0.3 MPa for 55 seconds, and the heat treatment was performed at 215°C for 30 minutes under a vacuum of 10^-3 Torr.

On the bottom side of the packaging substrate (facing the PCB bonding side), a solder resist layer having a thickness of 8 $\mu$m was formed. The curing temperature was 175°C, the curing time was 55 minutes, and the heating rate was 3.5°C/min. Thereafter, final heat treatment was performed at 245°C for 55 minutes under a vacuum of 5$\times$10^-4 Torr. In this process, the heating rate was 2.5°C/min and the cooling rate was 1.5°C/min. The completed substrate was stabilized for 22 hours in an environment of 23$\pm$2°C and 50$\pm$5% RH.

**3) Preparation of Example 3**

3-1) Preparation of Example 3-1: Cover Layer

The other conditions were applied in the same manner, except that the plating was performed at 25°C with a current density of 1.5 A/dm$^2$ for 16 minutes of electrolytic plating. The thickness of the copper wiring layer thus formed was 9.2 $\mu$m. The curing conditions for forming the insulating layer and the heat treatment conditions were also changed. The ABF lamination was performed at 105°C, 0.35 MPa for 65 seconds, and the heat treatment was performed at 220°C for 35 minutes under a vacuum of $8\times10$^-4 Torr.

On the top side of the packaging substrate (facing the semiconductor chip mounting side), a polyimide (PI) cover layer having a thickness of 11 $\mu$m was laminated. Spin coating was performed at 2800 rpm for 35 seconds, and curing was performed at 355°C for 65 minutes. The heating rate was 3.5°C/min, and the cooling rate was 1.5°C/min.

3-2) Preparation of Example 3-2: Solder Resist Layer

The other conditions were applied in the same manner, except that the plating was performed at 25°C with a current density of 1.5 A/dm$^2$ for 16 minutes of electrolytic plating. The thickness of the copper wiring layer thus formed was 9.2 $\mu$m. The curing conditions for forming the insulating layer and the heat treatment conditions were also changed. The ABF lamination was performed at 105°C, 0.35 MPa for 65 seconds, and the heat treatment was performed at 220°C for 35 minutes under a vacuum of $8\times10$^-4 Torr.

On the bottom side of the packaging substrate (facing the PCB bonding side), a solder resist layer having a thickness of 12 $\mu$m was formed. The curing temperature was 185°C, the curing time was 65 minutes, and the heating rate was 2.5°C/min. Thereafter, final heat treatment was performed at 255°C for 65 minutes under a vacuum of $3\times10$^-4 Torr. In this process, the heating rate was 1.5°C/min and the cooling rate was 1°C/min. The completed substrate was stabilized for 26 hours in an environment of $23\pm2$°C and $50\pm5$% RH.

**4) Preparation of Comparative Example 1**

A glass plate was cut into a size of 10 cm $\times$ 10 cm as a glass core, and then etched for 5 minutes in a mixed solution of 1.8 M hydrofluoric acid and 1.0 M nitric acid, rinsed with deionized water, and neutralized for 15 seconds with a 4.5 mol% sodium bicarbonate solution. After drying the glass core at 90°C for 15 minutes, titanium (Ti) 40 nm and copper (Cu) 100 nm seed layers were deposited on both the top and bottom surfaces by sputtering. The sputtering was performed at a power of 70 W in a 7 mTorr argon atmosphere. On the seed layers, copper wiring layers having a thickness of 1.2 $\mu$m were formed on both the top and bottom surfaces by electroplating, using an electrolytic solution of 0.4 M copper sulfate and 0.08 M sulfuric acid, at 25°C and a current density of 7 mA/cm$^2$ for 11 minutes. Subsequently, an Ajinomoto Build-up Film (ABF) having a thickness of 40 $\mu$m was laminated at 90°C, and then cured at 135°C for 40 minutes. Titanium (Ti) 40 nm and copper (Cu) 1.2 $\mu$m wiring layers were additionally formed on both the top and bottom surfaces under the same conditions to complete electrical connection.

4-1) Preparation of Comparative Example 1-1: Cover Layer

On the top side of the packaging substrate (facing the semiconductor chip mounting side), a polyimide (PI) cover layer having a thickness of 7 $\mu$m was formed. A polyimide solution was spin-coated on the top surface of the packaging substrate. Spin coating was performed at 2600 rpm for 25 seconds, and after coating, a soft bake was performed at 75°C for 8 minutes. Thereafter, curing was performed at 320°C for 40 minutes, with a heating rate of 3°C/min and a cooling rate of 2.5°C/min.

4-2) Preparation of Comparative Example 1-2: Solder Resist Layer

On the bottom side of the packaging substrate (facing the PCB bonding side), a solder resist layer having a thickness of 10 $\mu$m was formed. A composition for solder resist was applied by a screen printing method. After printing, preliminary drying was performed at 75°C for 10 minutes. Thereafter, curing was performed at 165°C for 45 minutes, with a heating rate of 2.5°C/min. The fully laminated substrate was then heat-treated at 235°C for 40 minutes under a vacuum of $5\times10$^-3 Torr to perform final bonding and property stabilization. In this process, the heating rate was adjusted to 1°C/min and the cooling rate to 0.8°C/min to minimize thermal stress.

Finally, the completed substrate was stabilized for 18 hours in an environment of $21\pm2$°C and $40\pm5$% RH.

**5) Preparation of Comparative Example 2**

5-1) Preparation of Comparative Example 2-1: Cover Layer

The other conditions were applied in the same manner, except that the plating was performed at 25°C with a current density of 1.7 A/dm$^2$ for 12 minutes of electrolytic plating. The thickness of the copper wiring layer thus formed was 7.2 $\mu$m. The curing conditions for forming the insulating layer and the heat treatment conditions were also changed. The ABF lamination was performed at 93°C, 0.23 MPa for 48 seconds, and the heat treatment was performed under a vacuum of $2 \times 10$^-3 Torr.

On the top side of the packaging substrate (facing the semiconductor chip mounting side), a polyimide (PI) cover layer having a thickness of 7 $\mu$m was laminated. Spin coating was performed at 3000 rpm for 25 seconds, and curing was performed at 330°C for 45 minutes. The heating rate was 4.5°C/min, and the cooling rate was 2.5°C/min.

5-2) Preparation of Comparative Example 2-2: Solder Resist Layer

The other conditions were applied in the same manner, except that the plating was performed at 25°C with a current density of 1.7 A/dm$^2$ for 12 minutes of electrolytic plating. The thickness of the copper wiring layer thus formed was 7.2 $\mu$m. The curing conditions for forming the insulating layer and the heat treatment conditions were also changed. The ABF lamination was performed at 93°C, 0.23 MPa for 48 seconds, and the heat treatment was performed at 200°C for 23 minutes under a vacuum of $2 \times 10^{-3}$ Torr.

On the bottom side of the packaging substrate (facing the PCB bonding side), a solder resist layer having a thickness of 9.5 $\mu$m was formed. The curing temperature was 165°C, the curing time was 48 minutes, and the heating rate was 3.5°C/min. Thereafter, final heat treatment was performed at 230°C for 45 minutes under a vacuum of $8 \times 10^{-4}$ Torr. In this process, the heating rate was 2.5°C/min and the cooling rate was 1.5°C/min. The completed substrate was stabilized for 18 hours in an environment of $21\pm2$°C and $40\pm5$% RH.

**6) Preparation of Comparative Example 3**

6-1) Preparation of Comparative Example 3-1: Cover Layer

The other conditions were applied in the same manner, except that the plating was performed at 25°C with a current density of 1.5 A/dm$^2$ for 15 minutes of electrolytic plating. The thickness of the copper wiring layer thus formed was 9 $\mu$m. The curing conditions for forming the insulating layer and the heat treatment conditions were also changed. The ABF lamination was performed at 102°C, 0.32 MPa for 62 seconds, and the heat treatment was performed at 215°C for 32 minutes under a vacuum of $6 \times 10^{-4}$ Torr.

On the top side of the packaging substrate (facing the semiconductor chip mounting side), a polyimide (PI) cover layer having a thickness of 8 $\mu$m was laminated. Spin coating was performed at 2600 rpm for 32 seconds, and curing was performed at 345°C for 62 minutes. The heating rate was 3°C/min, and the cooling rate was 1°C/min.

6-2) Preparation of Comparative Example 3-2: Solder Resist Layer

The other conditions were applied in the same manner, except that the plating was performed at 25°C with a current density of 1.5 A/dm$^2$ for 15 minutes of electrolytic plating. The thickness of the copper wiring layer thus formed was 9 $\mu$m. The curing conditions for forming the insulating layer and the heat treatment conditions were also changed. The ABF lamination was performed at 102°C, 0.32 MPa for 62 seconds, and the heat treatment was performed at 215°C for 32 minutes under a vacuum of $6 \times 10^{-4}$ Torr.

On the bottom side of the packaging substrate (facing the PCB bonding side), a solder resist layer having a thickness of 10.5 $\mu$m was formed. The curing temperature was 185°C, the curing time was 62 minutes, and the heating rate was 2°C/min. Thereafter, final heat treatment was performed at 245°C for 65 minutes under a vacuum of $3 \times 10^{-4}$ Torr. In this process, the heating rate was 1°C/min and the cooling rate was 0.8°C/min. The completed substrate was stabilized for 24 hours in an environment of $24\pm2$°C and $55\pm5$% RH.

**Evaluation Method**

1) DMA

DMA (Dynamic Mechanical Analyzer) measurement was performed. A DMA7100 manufactured by Hitachi was used, and the measured values were output using a program provided by the manufacturer.

Each sample was placed in the equipment, and the storage modulus (E') and the loss tangent (tan $\delta$) were measured while heating from about -40°C to about +210°C over approximately 70 minutes, and the results are shown in Table 1 below. The applied frequency was 1 Hz. The average values measured in the range of 25°C to 85°C are shown in Table 1 below.

2) Nanoindentation

For square samples, the diagonal length was measured, and a value corresponding to 1/20 of the diagonal length (distance value) was obtained and used as a reference for arranging measurement points. The measurement points were arranged such that each square sample was divided into four equal parts and 2 to 4 points were placed in each part, and the distances between the points satisfied the above distance value condition.

At each measurement point, the reduced modulus at the extreme surface was measured using a nanoindentation device. During measurement, the temperature was about 27°C, and the relative humidity was about 25%. The measurement device used was a NanoTest Vantage Platform (MICRO MATERIALS), and the measurement was performed by applying a Berkovich-type diamond tip indenter at a maximum load of 25 mN. The tip sharpness of the indenter was about 56.36 nm, and the effective radius was about 68.67 $\pm$ 1.48 nm. The measurement results were processed using software provided by the manufacturer of the measurement device to determine the hardness (H), reduced modulus (Er), elastic recovery coefficient, and contact compliance. The results are shown in Table 1 below.

In addition, the flexibility index (FI) was calculated according to Equation 1 above, and the results are shown in Table 1 below. In Equation 1, the storage modulus and loss tangent were measured for the packaging substrate as a whole, without separately measuring the cover layer and the solder resist layer, and thus the same values are shown.

[Table 1]

| | | Storage Modulus (E') [GPa] | Loss Tangent (tan δ) | Hardness (H) [GPa] | Reduced Modulus (Er) [GPa] | Flexibilit y Index (FI) |
|---|---|---|---|---|---|---|
| Example 1 | Example 1-1 (Cover Layer) | 0.807 | 0.0088 | 0.60603 | 14.36379 | 8.158 |
| | Example 1-2 (Solder Resist Layer) | 0.807 | 0.0088 | 0.87775 | 19.10333 | 4.235 |
| Example 2 | Example 2-1 (Cover Layer) | 0.781 | 0.009 | 0.61118 | 14.52118 | 7.92 |
| | Example 2-2 (Solder Resist Layer) | 0.781 | 0.009 | 0.88342 | 19.03247 | 4.181 |
| Example 3 | Example 3-1 (Cover Layer) | 0.758 | 0.0085 | 0.59543 | 14.03142 | 7.712 |
| | Example 3-2 (Solder Resist Layer) | 0.758 | 0.0085 | 0.85127 | 18.84591 | 4.016 |
| Comparati ve Example 1 | Comparative Example 1-1 (Cover Layer) | 0.956 | 0.0091 | 0.52215 | 15.81156 | 10.537 |
| | Comparative Example 1-2 (Solder Resist Layer) | 0.956 | 0.0091 | 0.78338 | 20.8515 | 5.326 |
| Comparati ve Example 2 | Comparative Example 2-1 (Cover Layer) | 0.653 | 0.0113 | 0.53159 | 16.25531 | 8.539 |
| | Comparative Example 2-2 (Solder Resist Layer) | 0.653 | 0.0113 | 0.79505 | 17.859 | 5.197 |
| Comparati ve Example 3 | Comparative Example 3-1 (Cover Layer) | 0.951 | 0.012 | 0.6933 | 12.5548 | 13.111 |
| | Comparative Example 3-2 (Solder Resist Layer) | 0.951 | 0.012 | 0.97559 | 21.2254 | 5.511 |

3) Thermal Shock Test

The thermal shock test was performed using a SE-600-10-10 model manufactured by Thermotron. This equipment provides the capability to rapidly switch temperatures between -55°C and 125°C, and is mainly used for evaluating the thermal reliability of electronic substrates and composite materials.

The test was conducted based on the IPC-TM-650 standard, with the transition time between high and low temperatures set to 10 seconds to induce rapid temperature changes. Each temperature was maintained for 30 minutes during the test. Strain was measured in real time using a high-resolution Keyence LK-G5000 device.

Samples were uniformly prepared in a size of 100 mm × 100 mm, and the test was conducted on substrates laminated with a cover layer and a solder resist layer.

The fracture temperature was recorded using a Thermal Imager Ti450 manufactured by Fluke, and the stress at the time of fracture was measured using an Instron 5967 Dual Column Testing System. This equipment is suitable for analyzing the fracture resistance of a substrate because it can accurately measure the stress at the moment the sample breaks. In the test, the samples were subjected to a temperature change from -55°C to 125°C, with each temperature maintained for 30 minutes, followed by cooling within 10 seconds, and this process was repeated. During the total cycles, the strain, fracture temperature, and stress at the time of fracture of the samples that did not break were recorded to evaluate the thermal durability of the substrate. The results are shown in Table 2 below.

[Table 2]

|  | Number of Thermal Shock Cycles | Strain (%) | Fracture Temperature (°C) | Stress at Fracture (MPa) |
|---|---|---|---|---|
| Example 1 | 1037 | 0.079 | 308.3 | 182.6 |
| Example 2 | 962 | 0.098 | 292.7 | 171.4 |
| Example 3 | 913 | 0.117 | 283.5 | 163.2 |
| Comparative Example 1 | 856 | 0.153 | 273.8 | 157.9 |
| Comparative Example 2 | 812 | 0.176 | 262.1 | 147.3 |
| Comparative Example 3 | 768 | 0.219 | 253.6 | 138.5 |

Referring to Tables 1 and 2 above, the examples recorded higher values in the number of thermal shock cycles, exhibited lower strain, and also showed higher fracture temperature and stress at fracture. This is considered to be the result of the storage modulus (E') and the reduced modulus (Er) measured in the cover layer and the solder resist layer being balanced within appropriate ranges, thereby providing excellent resistance to thermal stress. In particular, in the examples, the difference in flexibility index (FI) based on the values measured in the cover layer and the solder resist layer was relatively small, in the range of 3.7 to 3.9, which is believed to have minimized physical deformation caused by thermal shock. Due to this balance, it can be interpreted that strain was maintained at a low level and fracture temperature was higher in the thermal shock test.

In contrast, the comparative examples exhibited fewer thermal shock cycles than the examples, relatively higher strain, and lower fracture temperature and stress at fracture. This is believed to result from larger differences in physical properties between the cover layer and the solder resist layer. For example, in Comparative Examples 1 and 3, the storage modulus (E') values were high, 0.956 GPa and 0.951 GPa, respectively, which may make them more vulnerable to thermal stress. Conversely, in Comparative Example 2, the E' value was low at 0.653 GPa, which appears to reduce the overall mechanical strength and result in lower resistance to thermal shock. In addition, the differences in flexibility index (FI) in the comparative examples were significantly larger; in particular, Comparative Example 3 showed a difference of 7.6 between the upper and lower solder resist layers, which is a substantial difference compared to the examples. This imbalance in physical properties between the cover layers is considered to have had a negative impact on the durability of the substrate. Furthermore, the loss tangent (tan δ) values were relatively high in Comparative Examples 2 and 3, at 0.0113 and 0.012, respectively, which is considered to have increased energy loss during thermal shock and contributed to the deterioration of substrate performance.

4) Three-Point Bending Test

The three-point bending test was conducted using a 5967 Dual Column Testing System manufactured by Instron. This equipment is used to measure the bending strength and modulus of composites and substrates, and provides the capability to precisely measure the amount of deflection of a sample. The test was performed with reference to ASTM D790 standard and IPC-TM-650 2.4.4 Method A. The samples were cut to a size of 100 mm × 10 mm × 1.6 mm.

Each sample was a substrate laminated with a cover layer and a solder resist layer. The bending speed was set to 1 mm/min, adjusted according to the thickness of the sample. The support span between the two points was set to 80 mm, which is 16 times the sample thickness, so that an appropriate load could be applied to the sample.

During the test, the amount of deflection while the sample was bending was measured in real time at a sampling rate of 10 Hz using the high-precision load cell of the equipment, and the bending strength and modulus were automatically calculated by software. The test procedure was performed by placing the sample on two supports and applying a load at a constant speed at the center. The maximum load until the sample fractured was recorded, and based on this, the bending strength and bending modulus were calculated. For each sample type, five repeated tests were performed to obtain an average value. All tests were conducted under environmental conditions of 23 ± 2°C and 50 ± 5% RH. After completion of the test, the maximum bending strength (MPa), modulus (GPa), and deflection (mm) of each sample were recorded and analyzed.

[Table 3]

|  | Bending Strength (MPa) | Bending Modulus (GPa) | Deflection (mm) |
|---|---|---|---|
| Example 1 | 223.7 | 5.83 | 2.18 |
| Example 2 | 212.4 | 5.56 | 2.29 |
| Example 3 | 203.1 | 5.24 | 2.37 |
| Comparative Example 1 | 183.6 | 4.85 | 1.97 |
| Comparative Example 2 | 168.2 | 4.57 | 2.16 |
| Comparative Example 3 | 153.9 | 4.28 | 2.35 |

Referring to Tables 1 and 3 above, the difference in mechanical performance between the examples and the comparative examples was clearly confirmed. The examples recorded higher values in bending strength and modulus, which is considered to be due not only to the balance between the storage modulus (E') and hardness (H), but also to the reduced modulus (Er) being maintained at an appropriate level. It is believed that the harmony of physical properties between the upper insulating layer and the cover layer, and between the lower insulating layer and the solder resist layer, contributed to the ability of the substrate to withstand bending stress, and it was also confirmed that the difference in flexibility index (FI) was stably maintained in the range of 3.7 to 3.9. Due to this balance, the examples are considered to exhibit the ability to absorb deformation during bending while maintaining strength.

In contrast, the comparative examples recorded lower values in bending strength and modulus, which is believed to have resulted from imbalance in physical properties having a negative impact on mechanical performance. For example, in Comparative Example 1, despite the high storage modulus (E' = 0.956 GPa), there was a relatively low hardness (H) and imbalance in physical properties, and a reduction in bending strength was observed. In Comparative Example 2, the storage modulus (E' = 0.653 GPa) was low and the loss tangent (tan $\delta$ = 0.0113) was high, resulting in overall deterioration of mechanical performance. Comparative Example 3 exhibited a high storage modulus (E' = 0.951 GPa), but the difference in flexibility index (FI) between the upper insulating layer and the cover layer, and the lower insulating layer and the solder resist layer, was as large as 7.6, indicating significant imbalance. This was determined to be a major cause of deterioration in the mechanical stability of the packaging substrate. In addition, the high loss tangent (tan $\delta$ = 0.012) also contributed to increased deflection and performance degradation.

Furthermore, in the deflection analysis, Comparative Example 1 showed the smallest deflection (1.97 mm), which may have resulted from the high storage modulus and reduced modulus. However, such a result may have actually increased brittleness, leading to a decrease in bending strength and modulus. Comparative Examples 2 and 3 exhibited large deflection but lower bending strength and mechanical performance, which is because the high loss tangent increased energy loss, resulting in performance degradation. In conclusion, the examples demonstrated that the balance between each physical property plays an important role in improving mechanical performance, while the comparative examples showed that imbalance between physical properties led to deterioration in mechanical performance. This suggests that, in substrate design, harmony and balance between physical properties are more important than maximizing individual physical properties.

The packaging substrate of the embodiment may provide a packaging substrate in which a difference in physical properties between an upper portion and a lower portion of a glass core is adjusted, thereby improving thermal shock resistance, impact resistance, durability, reliability and the like.

While the present invention has been described in detail with reference to the preferred embodiments, the scope of the present invention is not limited thereto, and various modifications and improvements made by those skilled in the art using the basic concepts of the present invention defined in the following claims are also within the scope of the present invention.

**Claims**

1.   A packaging substrate comprising:

a glass core; a wiring layer; and an insulating layer,
wherein the glass core is a plate-shaped glass in which vias are disposed,

the wiring layer is an electrically conductive layer disposed on a surface of the glass core,

the insulating layer is a layer disposed in a space between the electrically conductive layers and comprising a mixture of a polymer resin and insulating particles,

the packaging substrate has an upper surface on which a semiconductor element is mounted and a lower surface facing the upper surface,

the insulating layer disposed on an upper portion of the glass core is an upper insulating layer,

a cover layer is further disposed on the upper insulating layer,

the insulating layer disposed on a lower portion of the glass core is a lower insulating layer,

a solder resist layer is further disposed on the lower portion of the lower insulating layer,

a flexibility index FI is a value represented by Equation 1 below,

and the FI of the cover layer is greater than the FI of the solder resist layer:

[Equation 1]

$$FI = 10{,}000 \times (E' \times \tan \delta) / (H \times Er)$$

wherein, in Equation 1, E' denotes a storage modulus (GPa), $\tan \delta$ denotes a loss tangent, H denotes a hardness (GPa), and Er denotes a reduced modulus (GPa).

2. The packaging substrate according to claim 1,
wherein the FI of the cover layer is in a range of 7.5 or more and 8.3 or less.

3. The packaging substrate according to claim 1 or claim 2,
wherein the FI of the solder resist layer is in a range of 3.9 or more and 4.6 or less.

4. The packaging substrate according to anyone from claim 1 to claim 3,
wherein a storage modulus (E') of the packaging substrate is in a range of 0.73 GPa or more and 0.85 GPa or less.

5. The packaging substrate according to anyone from claim 1 to claim 4,
wherein a loss tangent ($\tan \delta$) of the packaging substrate is in a range of 0.0080 or more and 0.0090 or less.

6. The packaging substrate according to anyone from claim 1 to claim 5,
wherein a hardness (H) of the cover layer is in a range of 0.55 GPa or more and 0.65 GPa or less.

7. The packaging substrate according to anyone from claim 1 to claim 6,
wherein a hardness (H) of the solder resist layer is in a range of 0.82 GPa or more and 0.93 GPa or less.

8. The packaging substrate according to anyone from claim 1 to claim 7,
wherein a reduced modulus (Er) of the cover layer is in a range of 13.5 GPa or more and 15.0 GPa or less.

9. The packaging substrate according to anyone from claim 1 to claim 8,
wherein a reduced modulus (Er) of the solder resist layer is in a range of 17.8 GPa or more and 19.6 GPa or less.

10. The packaging substrate according to anyone from claim 1 to claim 9,
wherein a difference between the FI of the cover layer and the FI of the solder resist layer is in a range of 3.6 or more and 4.2 or less.

FIG. 1

A-A'

FIG. 2

A–A'

400

410    430    300

210

## FIG. 3

A–A'

500    20

400

210

230

400

600

300

## FIG. 4

# EUROPEAN SEARCH REPORT

Europäisches
Patentamt
European
Patent Office
Office européen
des brevets

**Application Number**

EP 25 20 7398

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 9 736 927 B2 (SAMSUNG ELECTRO MECH [KR]) 15 August 2017 (2017-08-15) * paragraphs [0032] - [0065]; figure 3 * ----- | 1-10 | INV. H10W70/685 H10W70/69 H10W70/692 |
| X | US 2016/111380 A1 (SUNDARAM VENKATESH [US] ET AL) 21 April 2016 (2016-04-21) * paragraphs [0063] - [0065], [0107] - [0108]; figures 1,2,24D * ----- | 1-10 | |
| A | NAZMUS SAKIB A R ET AL: "Effects of Solder Mask Application Method on The Reliability of An Automotive Flip Chip PBGA Microcontroller", 2019 18TH IEEE INTERSOCIETY CONFERENCE ON THERMAL AND THERMOMECHANICAL PHENOMENA IN ELECTRONIC SYSTEMS (ITHERM) IEEE, 28 May 2019 (2019-05-28), pages 1139-1145, XP033575075, DOI: 10.1109/ITHERM.2019.8757373 [retrieved on 2019-07-08] * the whole document * ----- | 1-10 | TECHNICAL FIELDS SEARCHED (IPC) H10W |

The present search report has been drawn up for all claims

| Place of search | Date of completion of the search | Examiner |
|---|---|---|
| The Hague | 17 March 2026 | Rutsch, Gerald |

EPO FORM 1503 03.82 (P04C01)

## ANNEX TO THE EUROPEAN SEARCH REPORT
## ON EUROPEAN PATENT APPLICATION NO.

EP 25 20 7398

This annex lists the patent family members relating to the patent documents cited in the above-mentioned European search report.
The members are as contained in the European Patent Office EDP file on
The European Patent Office is in no way liable for these particulars which are merely given for the purpose of information.

17-03-2026

| Patent document cited in search report | | Publication date | Patent family member(s) | | Publication date |
|---|---|---|---|---|---|
| US 9736927 | B2 | 15-08-2017 | JP | 6690830 B2 | 28-04-2020 |
| | | | JP | 2016092406 A | 23-05-2016 |
| | | | KR | 20160055533 A | 18-05-2016 |
| | | | US | 2016135289 A1 | 12-05-2016 |
| US 2016111380 | A1 | 21-04-2016 | NONE | | |

EPO FORM P0459

For more details about this annex : see Official Journal of the European Patent Office, No. 12/82

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 63714154
- KR 1020200030430

- KR 1020230145447